Europäisches Patentamt

European Patent Office

Office européen des brevets

(19)

(11) Veröffentlichungsnummer: **0 073 420**
**B1**

(12) **EUROPÄISCHE PATENTSCHRIFT**

(45) Veröffentlichungstag der Patentschrift:
30.04.86

(51) Int. Cl.⁴: **H 03 J 5/02, H 04 B 1/08**

(21) Anmeldenummer: 82107568.6

(22) Anmeldetag: 19.08.82

(54) **Empfangsstufe für Rundfunk- und Fernseh-Empfänger.**

(30) Priorität: 26.08.81 DE 3133760

(43) Veröffentlichungstag der Anmeldung:
09.03.83 Patentblatt 83/10

(45) Bekanntmachung des Hinweises auf die Patenterteilung:
30.04.86 Patentblatt 86/18

(84) Benannte Vertragsstaaten:
BE CH FR LI LU NL SE

(56) Entgegenhaltungen:
DE - A - 1 958 993
DE - B - 2 542 902

IEEE TRANSACTIONS ON CONSUMER ELECTRONICS,
Band CE-27, Nr. 3, August 1981, Seiten 272-282, New
York, USA, G. d'ANDREA et al.: "Frequency synthesis
for color TV-receivers with a new dedicated
mu-computer"
GRUNDIG TECHNISCHE INFORMATIONEN, Band 26,
Nr. 1, 1979, Seiten 36-46, Furth, DE., M. HEGENDÖRFER
et al.: "Synthesizerabstimmung nach dem PLL-System
mit hoher Auflösung"
IEEE TRANSACTIONS ON CONSUMER ELECTRONICS,
Band CE-24, Nr. 3, August 1978, Seiten 419-425, New
York, USA, B.W. BEYERS et al.: "Frequency synthesis
tuning systems with automatic offset tuning"

(73) Patentinhaber: Deutsche Thomson-Brandt GmbH,
Hermann-Schwer-Strasse 3,
D-7730 Villingen-Schwenningen (DE)

(72) Erfinder: Geiger, Erich, Panoramablick 19,
D-7731 Unterkirnach (DE)
Erfinder: Maier, Gerhard, Reutestrasse 19,
D-7735 Dauchingen (DE)

## Beschreibung

Die Erfindung bezieht sich auf eine Empfangsstufe für Rundfunk- und Fernsehempfänger. Diese Empfänger sind mit einem Tuner versehen zur Selektierung der unterschiedlichen Senderfrequenzen der Rundfunk- bzw. Fernsehsendersignale. Die dem Tuner zugeführten Antennensignale werden in diesem durch Mischung mit einer Oszillatorfrequenz zu einer Zwischenfrequenz umgeformt. Die dem Tuner entnommenen Zwischenfrequenzsignale werden in einem nachgeschalteten Zwischenfrequenzverstärker verstärkt. Ein an den Zwischenfrequenzverstärker angeschlossener Demodulator demoduliert das hochfrequente modulierte Signal zu einem audiofrequenten Tonsignal bzw. zu einem videofrequenten Bildsignal, welches den Endstufen zur Wiedergabe in einem Lautsprecher bzw. auf dem Bildschirm einer Fernsehbildröhre zugeführt wird. Die einzelnen Baueinheiten wie Tuner, ZF-Verstärker und Demodulator waren üblicherweise in getrennten Bauteilen angeordnet und über Leitungen miteinander verbunden. Diese Leitungen müssen abgeschirmt sein und sind deshalb teuer. Die notwendigen Steckverbindungen sind störanfällig und bilden Quellen von Störungen, die von außen in die Empfangsanlage gelangen können. Es wurde deshalb vorgeschlagen, diese genannten Baueinheiten in einem Gehäuse zusammenzufassen. Dadurch ergibt sich eine optimale Abschirmung und der Wegfall von langen dem Einfluss von Störungen ausgesetzten Verbindungsleitungen (DE-AS 1 958 993).

Empfangsgeräte der neueren Technik besitzen Kapazitätsdioden in den Abstimmkreisen. Die zur Abstimmung erforderliche Abstimmspannung wird dabei durch Frequenzsynthese mit Hilfe einer PLL-Schaltung erzeugt. Diese PLL-Schaltung liefert eine Gleichspannung die sich in Abhängigkeit von einem vorwählbaren Teilerverhältnis eines Frequenzteilers der PLL-Schleife ergibt. Es ergibt sich jedoch der Nachteil, daß auf die Leitungen zur Dateneingabe zur PLL-Schaltung Störimpulse gelangen, die die Abstimmung beeinträchtigen können.

Der Erfindung liegt deshalb die Aufgabe zugrunde, auch diese Möglichkeit von Störeinflüssen noch zu beseitigen.

Diese Aufgabe wird dadurch gelöst, daß die Eingabeeinheit nach erfolgter Dateneingabe abgeschaltet wird.

### Beschreibung:

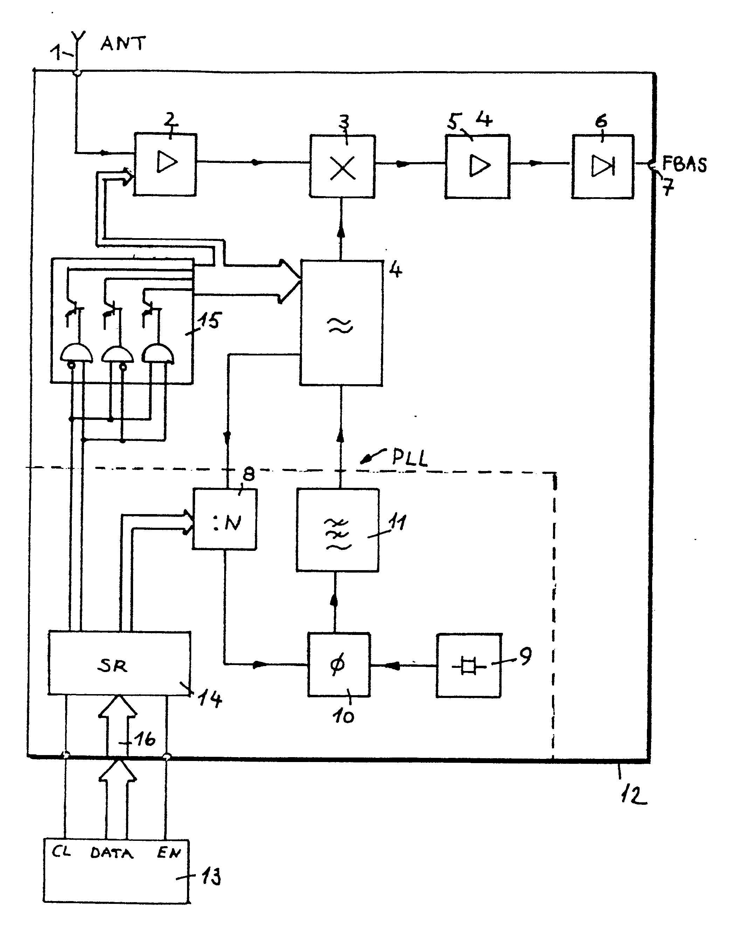

Mit Hilfe der Zeichnung wird nachstehend das Wesentliche der Erfindung näher erläutert. Die von der Antenne 1 empfangenen Signale werden in bekannter Weise in einem Vorverstärker 2 verstärkt. In der Mischstufe 3 zusammen mit der aus dem Oszillator 4 erhaltenen Frequenz zu einer Zwischenfrequenz gemischt. Die Schwingungen werden in dem ZF-Verstärker 5 verstärkt und dann mit Hilfe des Demodulators 5 demoduliert, dessen Ausgangssignal FBAS am Anschluß 7 entnommen werden kann. Die vorgenannten Stufen sind in einem Gehäuse innerhalb einer einzigen Abschirmung untergebracht, wie es bereits in der DE-AS 1 958 993 beschrieben worden ist.

Die Bauteile für die PLL-Schaltung - programmierbarer Vorteiler 8 - Referenzquelle 9 Phasenvergleichstufe 10 - Tiefpassfilter 11 zur Erzeugung der Abstimmspannung sind mit in das gleiche Gehäuse 12 integriert. Über eine von aussen an das Gehäuse 12 angeschlossene Eingabeeinheit 13 können den anzuwählenden Kanal bestimmte Daten eingegeben werden und den Vorteiler 8 sowie den Bandschalter 15 einstellen. Nach der Eingabe der Daten über die Datenleitung 18 sowie über den Clockeingang CL und den Enable-Eingang EN werden diese nach der Lehre der Erfindung abgeschaltet, so daß auch Störimpulse die PLL-Schaltung nicht mehr beeinflussen können.

## Patentanspruch

1. Empfangsstufe für Rundfunk- und Fernsehempfänger mit einem Tuner und einem Zwischenfrequenzverstärker, einem an den Zwischenfrequenzverstärker angeschalteten Demodulator sowie einer zur Abstimmung von mit Kapazitätsdioden versehenen Abstimmkreisen dienenden PLL-Schaltung mit einem vorprogrammierbaren Frequenzteiler, einer Referenzquelle, einer Phasenvergleichsstufe und einem Tiefpaßfilter, wobei die Empfangskreise, ZF-Stufen, der Demodulator und der Frequenzteiler der PLL-Schaltung in einem gemeinsamen, einen Baustein bildenden Abschirm-Gehäuse angeordnet sind, wobei die gesamte PLL-Schaltung (8 bis 10, 14) in diesem Abschirm-Gehäuse (12) untergebracht ist und die den anzuwählenden Kanal bestimmenden Daten über eine Eingabeeinheit (13) eingebbar sind, dadurch gekennzeichnet, daß die Eingabeeinheit (13) nach erfolgter Dateneingabe abschaltbar ist.

## Claim

Receiver stage for radio- and television-sets having a tuner and an IF-amplifier, a demodulator connected with the IF-amplifier, as well as a PLL-circuit for tuning of tuning-circuits having varactors, whereby the receiving-circuits, the IF-stages and the demodulator are united in one common housing forming a block, characterized in that the PLL-ciruit is united in this housing.

## Revendication

Etage de réception pour des récepteurs de radio et detélévision comportant un tuner et un amplificateur de fréquence intermédiaire, un démodulateur relié à l'amplificateur de fréquence intermédiaire ainsi qu'un circuit PLL servant à l'accord en vue d'assurer l'accorde de circuits d'accord pourvus de diodes capacitives, les circuits de réception, les étages de fréquence intermédiaire et de démodulateur étant disposés dans un carter commun formant un module, caractérisé en ce que le circuit PLL est logé dans ce carter.

0 073 420